# EUROPÄISCHE PATENTSCHRIFT

(11) **EP 0 682 412 B1**
(45) Veröffentlichungstag und Bekanntmachung des Hinweises auf die Patenterteilung: **08.08.2001**
(21) Anmeldenummer: 95201191.4
(22) Anmeldetag: 09.05.1995
(51) Int. Cl.: H03L 1/02

(54) **Schaltungsanordnung mit einer zusammengesetzten Übertragungsfunktion**
Circuit with a composite transfer function
Circuit a fonction de transfert composite

(30) Priorität: 13.05.1994 DE 4416981
(43) Veröffentlichungstag der Anmeldung: 15.11.1995
(73) Patentinhaber: Philips Corporate Intellectual Property GmbH, 52064 Aachen (DE); Koninklijke Philips Electronics N.V., 5621 BA Eindhoven (NL)
(72) Erfinder: Wichern, Andreas, c/o Philips Patentverw. GmbH, D-20097 Hamburg (DE)
(74) Vertreter: Peters, Carl Heinrich, Dipl.-Ing.

(56) Entgegenhaltungen:
- EP-A- 0 401 919
- DE-A- 3 008 686
- DE-A- 3 027 071
- GB-A- 1 224 165
- GB-A- 2 223 902
- US-A- 3 454 903
- US-A- 3 821 665
- PROCEEDINGS OF THE 41 TH ANNUAL FREQUENCY SYMPOSIUM, 1987, PHILADELPHIA US Seiten 539 - 543 A. HARRISON ET AL 'High frequency stable frequency sources for advanced systems'

## Beschreibung

Die Erfindung betrifft eine Schaltungsanordnung nach dem Oberbegriff des Patentanspruchs 1. Die Erfindung betrifft ferner eine Schaltungsanordnung nach dem Oberbegriff des Patentanspruchs 3.

Aus dem Aufsatz "CAD Simplifies TCXO Design" von Paul Faerber und Alan Victor, erschienen im "Oscillator Design Handbook", ist ein Netzwerk bekannt, mit dem die Resonanzfrequenz eines Schwingquarzes, die eine nichtlineare Funktion der Temperatur darstellt, kompensiert werden kann. Dazu wird eine Eingangsspannung Vᵢ über das genannte Netzwerk in eine temperaturabhängige Ausgangsspannung Vₒ umgewandelt, die als Stellspannung einer Varactordiode zugeleitet wird. Diese Varactordiode ist mit dem Schwingquarz in Reihe geschaltet und ermöglicht eine Einstellung der Resonanzfrequenz der Gesamtanordnung aus Varactordiode und Schwingquarz über die Eingangsspannung Vᵢ. Das Netzwerk enthält zur Temperaturkompensation des Schwingquarzes mehrere Thermistoren, um eine Kompensation der nichtlinearen Temperatur-Resonanzfrequenz-Kennlinienfunktion des Schwingquarzes zu ermöglichen. Im allgemeinen sind für ein solches Netzwerk bestimmte Kombinationen von Bauteilen mit positiven und negativen reaktiven Temperaturkoeffizienten erforderlich. In einem in der genannten Literaturstelle gezeigte Beispiel werden drei Thermistoren mit negativen Temperaturkoeffizienten in spezieller Verbindung mit weiteren Widerständen benötigt. Wie aus der aufgeführten Literaturstelle weiterhin erkennbar ist, kann mit einem solchen Netzwerk eine teilweise Kompensation der Temperatur-Resonanzfrequenz-Kennlinienfunktion des Schwingquarzes erzielt werden.

Die Schaltungsanordnungen nach dem Stand der Technik haben jedoch den Nachteil, daß eine nur sehr unvollkommene Kompensation mit hohem Schaltungsaufwand erhalten wird. Dieser hohe Schaltungsaufwand resultiert einerseits daraus, daß die unterschiedlichen zu verwendenden Thermistoren nicht integrierbar sind, andererseits daraus, daß das erhaltene Netzwerk sehr schwierig und umständlich abzugleichen ist. Eine kostengünstige Fertigung von kompakten, temperaturkompensierten Oszillatoren ist damit nicht möglich.

Eine weitere Möglichkeit zur Temperaturkompensation eines Schwingquarzes könnte darin bestehen, der Varactordiode (d.h. Kapazitätsdiode) eine durch einen Digital-Analog-Wandler erzeugte Spannung zuzuführen, der seine Eingangssignale aus einem Speicher zugeführt bekommt. In diesem Speicher kann für jede Temperatur eine bestimmte Datenfolge abgespeichert sein, welche mit Hilfe des Digital-Analog-Wandlers den Temperaturgang des Schwingquarzes kompensiert. Der Speicher muß dazu in Abhängigkeit von der Temperatur des Schwingquarzes ausgelesen werden. Obgleich eine derartige Lösung grundsätzlich auf einem Halbleiterkörper integrierbar und damit verhältnismäßig kompakt aufbaubar sein dürfte, erfordert sie einen hohen Schaltungsaufwand, insbesondere dann, wenn ein nachträglicher Abgleich des Temperaturgangs ermöglicht werden soll.

Aus der DE 30 08 686 A1 ist eine Temperaturkompensationsanordnung für einen Oszillator mit einem die Frequenz bestimmenden Kristall und mit einer spannungsveränderlichen Reaktanz bekannt, die mit dem Kristall verbunden ist, um die Oszillatorfrequenz in Reaktion auf eine Steuerspannung zu verändern, die der Reaktanz zugeführt wird. In dieser Anordnung ist ein erster Generator vorgesehen, um einen ersten Strom zu liefern, der eine im wesentlichen lineare Strom-Temperatur-Charakteristik in einem mittleren Temperaturbereich und eine nichtlineare entsprechende Charakteristik sowohl in einem höheren als auch in einem tieferen Bereich der Temperatur aufweist. Ein zweiter Stromgenerator ist vorhanden, um einen zweiten Strom zu liefern, der eine nichtlineare Strom-Temperatur-Charakteristik in einem Bereich tiefer Temperaturen aufweist. Der zweite Stromgenerator enthält eine Schaltung, welche dazu dient, den Betriebstemperaturbereich der zweiten Stromgeneratorschaltung zu bestimmen. Ferner ist ein dritter Stromgenerator vorgesehen, um einen dritten Strom zu liefern, der eine im wesentlichen nichtlineare Strom-Temperatur-Charakteristik im Bereich hoher Temperaturen aufweist. Der dritte Stromgenerator enthält eine Schaltung, welche dazu dient, den Betriebstemperaturbereich des dritten Stromgenerators einzustellen. Außerdem ist eine Schaltung vorgesehen, welche den ersten, den zweiten und den dritten Strom summiert, um einen Summenstrom zu bilden, und welche eine Steuerspannung mit einer Spannungs-Temperatur-Charakteristik erzeugt, welche der Strom-Temperatur-Charakteristik der Stromsumme proportional ist, wodurch die Oszillatorfrequenz auf einem im wesentlichen konstanten Wert über alle Temperaturbereiche hält.

Die Erfindung hat demgegenüber die Aufgabe, eine Schaltungsanordnung zu schaffen, mit der auf einfache Weise eine Gesamtübertragungsfunktion dargestellt werden kann, durch die beispielsweise die Kompensation des Temperaturgangs eines Schwingquarzes mit sehr einfachen und kompakten Mitteln ermöglicht wird, die aber darüber hinaus auch universell einsetzbar ist.

Diese Aufgabe wird erfindungsgemäß gelöst durch eine Schaltungsanordnung gemäß dem Patentanspruch 1.

Der Erfindung liegt die Erkenntnis zugrunde, daß eine wesentliche Vereinfachung dadurch erzielt werden kann, daß im vorgenannten Beispiel nach dem Stand der Technik eine Kompensation einer nichtlinearen Charakteristik dadurch vorgenommen wird, daß eine Meßgröße, hier die Temperatur im wesentlichen linear aufgenommen und auf elektrische bzw. elektronische Weise aus dieser einen, einzigen Aufnahme der Meßgröße ein entsprechend der gewünschten Kompensation nichtlinear mit der Meßgröße verknüpftes Ausgangssignal erzeugt wird. Dabei wird durch die Erfindung eine wesentlich kompaktere und einfacher zu handhabende Lösung bereitgestellt als die vorstehend erörterte Möglichkeit mit einem Speicher und einem Digital-Analog-Wandler.

Die Erfindung geht weiterhin von der Erkenntnis aus, daß die Temperatur-Resonanzfrequenz-Kennlinienfunktion eines Schwingquarzes im interessierenden Temperaturbereich wenigstens näherungsweise einer Funktion dritten Grades, d.h. einer kubischen Funktion entspricht, bei der mit anderen Worten die Resonanzfrequenz mit der dritten Potenz der Temperatur variiert. Gemäß der Erfindung wird dann für die Kompensation des Temperaturgangs eines solchen Schwingquarzes eine Schaltungsanordnung mit einer Gesamtübertragungsfunktion zur Verfügung gestellt, die ebenfalls einer Funktion dritten Grades entspricht, welche derart dimensioniert ist, daß ein im wesentlichen linear von der Temperatur abhängiges Eingangssignal der Schaltungsanordnung in ein Ausgangssignal umgewandelt wird, mit welchem über z.B. eine Kapazitätsdiode die Veränderungen der Resonanzfrequenz des Schwingquarzes über der Temperatur kompensiert werden können.

Die Erfindung schafft jedoch darüber hinaus auch eine Schaltungsanordnung mit einer Gesamtübertragungsfunktion höheren Grades, d.h. eine Abhängigkeit des Ausgangssignals von höheren Potenzen des Eingangssignals als der dritten Potenz. Damit können auch kompliziertere Gesamtübertragungsfunktionen auf einfache Weise erzeugt werden, die beispielsweise für die Kompensation komplizierterer Temperaturgänge, aber auch für andere Verwendungszwecke, sehr universell einsetzbar sind.

Die gemäß der Erfindung überlagerten Einzelübertragungsfunktionen der einzelnen Differenzverstärker sind dabei mit sehr einfachen Mitteln zu erzeugen, da sie den üblichen Kennlinien beispielsweise einfacher TransistorDifferenzverstärker entsprechen. Derartige Einzelübertragungsfunktionen, d.h. Differenzverstärker-Kennlinien weisen im Bereich geringer Differenzspannungen an ihren Eingängen einen wenigstens nahezu linearen Zusammenhang zwischen den zugeführten Differenzspannungen und von den Differenzverstärkern abgegebenen Ausgangsspannungen auf. Diese Kennlinienabschnitte sind hier als lineare Bereiche bezeichnet.

Bei einem solchen Differenzverstärker zugeführten höheren Differenzspannungen erreichen die vom Differenzverstärker abgegebenen Spannungen Werte, die bei weiterer Erhöhung der zugeführten Differenzspannung nicht mehr überschritten werden. Diese Werte sind hier als Grenzwerte, die zugehörigen Wertebereiche der zugeführten Differenzspannungen als Sättigungsbereiche und die Punkte der Einzelübertragungsfunktionen der Differenzverstärker, die einer zugeführten Differenzspannung Null entsprechen, sind als Nullpunkte bezeichnet. Diese Nullpunkte sind bei den genannten Differenzverstärkern über an wenigstens einem ihrer Eingänge zuzuführende Referenzspannungen bzw. - ströme vorgebbar.

Die Überlagerung der Einzelübertragungsfunktionen mit abwechselnd positivem und negativem Vorzeichen zur Gesamtübertragungsfunktion kann bevorzugt dadurch ausgeführt werden, daß allen Differenzverstärkern der Schaltungsanordnung ein Eingangssignal gleichsinnig zugeführt wird, wohingegen die Ausgangssignale der einzelnen Differenzverstärker wechselweise gleich- und gegensinnig additiv verknüpft werden. Dabei kann beginnend mit einer ersten Einzelübertragungsfunktion, derart fortlaufend vorgegangen werden, daß eine zweite Einzelübertragungsfunktion der ersten gegensinnig überlagert wird, wobei die zweite Einzelübertragungsfunktion gegenüber der ersten in ihrem Verlauf durch Abwandlung der Steigung, Grenzwerte und/oder des Nullpunktes derart modifiziert ist, daß sich beim Überlagern je einer zusätzlichen Einzelübertragungsfunktion je zwei zusätzliche Wendepunkte der resultierenden Gesamtübertragungsfunktion ergeben.

In einer bevorzugten Ausführungsform der Schaltungsanordnung nach der Erfindung ist demgemäß die Gesamtübertragungsfunktion aus Übertragungsfunktionen von wenigstens zwei Differenzverstärkern mit unterschiedlichen Steigungen in ihren linearen Bereichen und mit bezüglich der Reihenfolge abnehmender Steigungen monoton zunehmenden Grenzwerten in ihren Sättigungsbereichen mit in derselben Reihenfolge abwechselnd positivem und negativem Vorzeichen überlagert.

Auch der Aufbau dieser vereinfacht ausgebildeten Gesamtübertragungsfunktion kann sukzessive vorgenommen werden. Dabei wird einer ersten Einzelübertragungsfunktion mit der größten Steigung und den niedrigsten Grenzwerten mit positivem Vorzeichen eine zweite Einzelübertragungsfunktion mit um einen bestimmten Betrag verminderter Steigung, jedoch vergrößerten Grenzwerten mit negativem Vorzeichen überlagert. Die Nullpunkte der Einzelübertragungsfunktionen sind dabei bevorzugt identisch. Dabei entsteht bereits eine Gesamtübertragungsfunktion mit gegenüber einer Einzelübertragungsfunktion eines einfachen Differenzverstärkers zwei zusätzlichen Wendepunkten. Diese Gesamtübertragungsfunktion weist in einem Bereich um ihren Nullpunkt und die angrenzenden Wendepunkte herum einen Verlauf auf, der wenigstens nahezu einer Funktion dritten Grades entspricht.

Durch Überlagern einer weiteren Einzelübertragungsfunktion mit übereinstimmendem Nullpunkt, jedoch weiter verringerter Steigung und erhöhten Grenzwerten gegenüber der zweiten Einzelübertragungsfunktion, jetzt wieder mit positivem Vorzeichen ergeben sich in der Gesamtübertragungsfunktion zwei weitere Wendepunkte, wodurch die Gesamtübertragungsfunktion wenigstens näherungsweise einer Funktion entsprechend höheren Grades zumindest in der Umgebung des Nullpunktes und der insgesamt erhaltenen Wendepunkte entspricht.

Dieser Gesamtübertragungsfunktion können weitere Einzelübertragungsfunktionen mit weiter verringerten Steigungen und weiter erhöhten Grenzwerten, d.h. in der Reihenfolge abnehmender Steigungen monoton zunehmenden Grenzwerten, mit in gleicher Reihenfolge abwechselnd positivem und negativem Vorzeichen überlagert werden, wodurch bei jeder weiteren Einzelübertragungsfunktion zwei neue Wendepunkte entstehen.

Erfindungsgemäß wird die Aufgabe ferner gelöst durch eine Schaltungsanordnung gemäß dem nebengeordneten Patentanspruch 3. Bei dieser Ausformung der erfindungsgemäßen Lehre werden bevorzugt Einzelübertragungsfunktionen mit übereinstimmenden Steigungen und Grenzwerten eingesetzt. Auch hierbei kann von einer ersten Einzelübertragungsfunktion mit einem ersten Nullpunkt ausgegangen werden, der mit umgekehrtem Vorzeichen eine zweite Einzelübertragungsfunktion mit gegenüber dem ersten Nullpunkt zu höheren Werten hin verschobenem, zweitem Nullpunkt überlagert ist. Dadurch entsteht eine Funktion mit einem Maximum, das im Zusammenhang mit der Erläuterung der vorliegenden Erfindung auch als ein erster Wendepunkt bezeichnet werden kann. Mit gegenüber der zweiten Einzelübertragungsfunktion wiederum umgekehrtem Vorzeichen und gegenüber dem zweiten Nullpunkt der zweiten Einzelübertragungsfunktion noch einmal in gleicher Richtung verschobenem Nullpunkt wird dann eine dritte Einzelübertragungsfunktion eines dritten Differenzverstärkers überlagert, wodurch ein weiterer Wendepunkt (z.B. Minimum) entsteht. Insgesamt wird dann eine wenigstens nahezu kubische Gesamtübertragungsfunktion erhalten, die durch vorzeichenrichtige Überlagerung weiterer Einzelübertragungsfunktionen mit entsprechend weiter verschobenen Nullpunkten sehr einfach zu einer Funktion auch höheren Grades erweitert werden kann.

Die Erfindung bietet sowohl in ihrer allgemeinsten Fassung als auch in ihren speziellen Ausgestaltungen den Vorteil, daß die durch sie geschaffene Schaltungsanordnung auf einfache Weise eine leicht abgleichbare und vor allen Dingen mit geringem Aufwand auf einem Halbleiterkörper integrierbare Vorrichtung zur Darstellung von Gesamtübertragungsfunktionen dritten oder höheren Grades gebildet werden können. Diese Gesamtübertragungsfunktion ist durch Variation der Steigungen, Grenzwerte und/oder Nullpunkte der verwendeten Einzelübertragungsfunktionen leicht an die unterschiedlichsten Eigenschaften und Vorgaben anpaßbar. Beispielsweise bei einem Einsatz zur Kompensation der Temperatur-Resonanzfrequenz-Kennlinienfunktion eines Schwingquarzes kann so die erfindungsgemäße Schaltungsanordnung einfach und präzise den vorgegebenen Kennwerten des Schwingquarzes angepaßt werden, wodurch auch Schwingquarze stark unterschiedlicher Verläufe ihrer Kennlinienfunktionen zuverlässig in ihrem Temperaturgang kompensierbar sind. Werden beispielsweise einzelne oder alle Steigungen, Grenzwerte und/oder Nullpunkte der eingesetzten Differenzverstärker einstellbar ausgeführt, vorzugsweise durch einstellbare Referenzspannungen bzw. -ströme kann auch eine fertig dimensionierte Schaltungsanordnung gemäß der Erfindung nachträglich leicht an unterschiedliche Verläufe gewünschter Gesamtübertragungsfunktionen angepaßt bzw. abgeglichen werden.

In einer anderen Ausgestaltung der erfindungsgemäßen Schaltungsanordnung, in der die Gesamtübertragungsfunktion zumindest abschnittsweise wenigstens nahezu eine Funktion dritten Grades darstellt und die in der bereits erwähnten Weise zur Kompensation des Temperaturgangs eines Schwingquarzes eingesetzt wird, ist diese Schaltungsanordnung weiterhin verbunden mit
- einem Schwingquarz mit einer Temperatur-Resonanzfrequenz-Kennlinienfunktion, die zumindest abschnittsweise wenigstens nahezu einer Funktion dritten Grades entspricht,
- einem Stellelement zum Einstellen der Resonanzfrequenz durch ein Stellsignal mit wenigstens nahezu linearer Übertragungscharakteristik zwischen dem Stellsignal und der Resonanzfrequenz,
- einem Meßelement zum Bilden eines Meßsignals, dessen Wert wenigstens nahezu linear von der Temperatur des Schwingquarzes abhängig ist,
wobei das Meßsignal der Schaltungsanordnung als Eingangssignal zuführbar ist, die das daraus entsprechend der Gesamtübertragungsfunktion abgeleitete Ausgangssignal dem Stellelement als Stellsignal derart zuführt, daß die Resonanzfrequenz des mit dem Stellelement gekoppelten Schwingquarzes im genannten Abschnitt wenigstens nahezu von der Temperatur unabhängig ist.

Eine derartige Ausgestaltung der erfindungsgemäßen Schaltungsanordnung und Verbindung mit den weiterhin genannten Bauteilen stellt eine bevorzugte Anwendung der erfindungsgemäßen Schaltungsanordnung dar, jedoch ist ihre Anwendung nicht darauf beschränkt. Vielmehr können auch andere Gesamtübertragungsfunktionen mit höherem Grad zur Kompensation anderer Temperaturabhängigkeiten, aber auch ganz allgemein zur Darstellung vorgebbarer, funktionaler Zusammenhänge gebildet werden. Insbesondere bei der Umsetzung nicht elektrischer Meßgrößen in elektrische Signale und deren Weiterverarbeitung ist dabei der Vorteil gegeben, daß die Umsetzung der nicht elektrischen Meßgrößen mit einfachen, insbesondere linearen Anordnungen vogenommen werden kann.

Eine andere, vorteilhafte Ausgestaltung der erfindungsgemäßen Schaltungsanordnung ist dadurch gekennzeichnet, daß die darin verwendeten Differenzverstärker je ein Transistorenpaar aufweisen, dessen Emitteranschlüsse über wenigstens einen Emitterwiderstand gekoppelt sind, wobei die Steigungen der Einzelübertragungsfunktionen der Differenzverstärker in ihren linearen Bereichen durch die Wahl der Widerstandswerte der Emitterwiderstände bestimmbar sind.

Diese Ausgestaltung der Differenzverstärker zur Linearisierung ihrer Einzelübertragungsfunktionen stellt eine einfache und zuverlässige Lösung dar. Die dafür nötigen Emitterwiderstände können jedoch bei hohen Widerstandswerten und einer Integration auf einem Halbleiterkörper zu einem unerwünschten Flächenbedarf auf diesem Halbleiterkörper führen. Wahlweise kann daher eine Linearisierung, d.h. eine Verringerung der Steigungen der Einzelübertragungsfunktionen der Differenzverstärker ohne den Einsatz von Emitterwiderständen in der erfindungsgemäßen Schaltungsanordnung dadurch erreicht werden, daß die darin verwendeten Differenzverstärker je ein erstes und zweites Paar erster und zweiter emittergekoppelter, bipolarer, flächiger Transistoren aufweisen, wobei Basis- und Kollektoranschluß des ersten Transistors des ersten Paares mit dem entsprechenden Anschluß des ersten Transistors des zweiten Paares und Basis- und Kollektoranschluß des zweiten Transistors des ersten Paares mit dem entsprechenden Anschluß des zweiten Transistors des zweiten Paares gekoppelt ist und die Emitterflächen des zweiten Transistors des ersten Paares und des ersten Transistors des zweiten Paares einander gleich und um einen vorgegebenen Faktor größer oder kleiner sind als die einander gleichen Emitterflächen der beiden anderen Transistoren.

An dieser Stelle sei bemerkt, daß es aus der DE-OS 30 27 071 bereits bekannt ist, einen Transistorverstärker mit einem ersten Transistorpaar, das einen ersten und einen zweiten Transistor enthält, und mit einem zweiten Transistorpaar, das einen dritten und vierten Transistor enthält, wobei die Emitterelektroden der Transistoren jedes Paares miteinander verbunden sind, auszustatten. Darin sind die Basis- und die Kollektorelektrode des ersten Transistors mit der entsprechenden Elektrode des dritten Transistors und die Basis- und Kollektorelektrode des zweiten Transistors mit der entsprechenden Elektrode des vierten Transistors gekoppelt. Die Basiselektrode des ersten bzw. dritten Transistors einerseits und die Basiselektrode des zweiten bzw. vierten Transistors andererseits sind mit je einer Klemme einer Signalquelle gekoppelt, und das Ausgangssignal ist aus den Kollektorströmen der Transistoren ableitbar. In die gemeinsamen Emitterzuleitungen der beiden Transistorpaare sind einander entsprechende Stromquellen geschaltet, und die Transistoren sind so ausgebildet, daß die Emitterflächen des zweiten und des dritten Transistors einander gleich und um einen bestimmten Faktor größer oder kleiner als die einander gleichen Emitterflächen des ersten und des vierten Transistors. Dadurch sind die Kollektorgleichströme durch den ersten und den vierten Transistor einander gleich und um den genannten Faktor größer oder kleiner als die einander gleichen Kollektorgleichströme durch den zweiten und den dritten Transistor. Durch diese bekannte Anordnung können nichtlineare Verzerrungen eines aus einem einfachen Transistorpaar gebildeten Differenzverstärkers verringert, dessen Kennlinie also linearisiert werden, wodurch sich die Steigung dieser Kennlinie im Bereich um ihren Nullpunkt verringert. Eine derartige Schaltungsanordnung kommt ohne Emitterwiderstände aus und kann somit unter bestimmten Voraussetzungen noch kompakter aufgebaut werden als die vorstehend beschriebene Ausbildung der Differenzverstärker mit Emitterwiderständen.

Einige Ausführungsbeispiele der Erfindung sind in der Zeichnung dargestellt und werden im nachfolgenden näher beschrieben. Es zeigen
- Fig. 1: ein erstes Ausführungsbeispiel einer erfindungsgemäßen Schaltungsanordnung in Verbindung mit einem Meßelement,
- Fig. 2: ein Diagramm, in dem ein Strom am Ausgang der Anordnung nach Fig. 1 über der Temperatur aufgetragen ist,
- Fig. 3: ein weiteres Ausführungsbeispiel einer erfindungsgemäßen Schaltungsanordnung,
- Fig. 4: die Gesamtübertragungsfunktion der Schaltungsanordnung nach Fig. 3,
- Fig. 5: ein drittes Ausführungsbeispiel der erfindungsgemäßen Schaltungsanordnung und
- Fig. 6: die Gesamtübertragungsfunktion der Schaltungsanordnung nach Fig. 5.

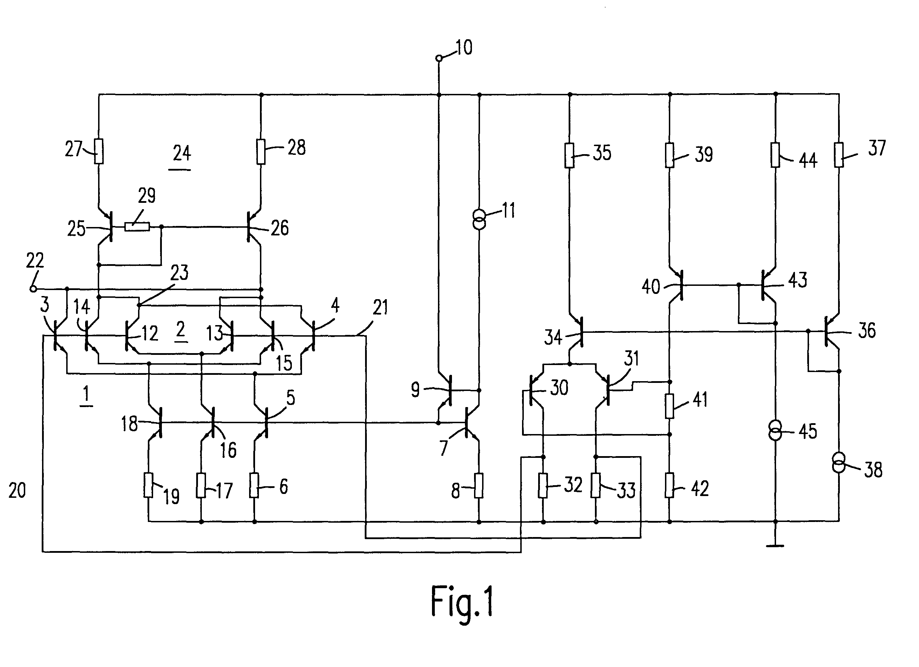

Die Schaltungsanordnung nach Fig. 1 umfaßt einen ersten, nicht linearisierten Differenzverstärker 1 und einen zweiten, linearisierten Differenzverstärker 2. Der erste Differenzverstärker 1 weist im linearen Bereich seiner Einzelübertragungsfunktion eine größere Steigung auf als der zweite Differenzverstärker 2, dafür weist die Einzelübertragungsfunktion des zweiten Differenzverstärkers 2 in ihren Sättigungsbereichen höhere Grenzwerte auf als die Einzelübertragungsfunktion des ersten Differenzverstärkers. Beide Differenzverstärker 1, 2 haben im vorliegenden Fall übereinstimmende Nullpunkte.

Der erste Differenzverstärker 1 enthält ein Paar emittergekoppelter Transistoren 3, 4, deren Emitteranschlüsse gemeinsam mit einem Kollektoranschluß eines ersten Stromquellentransistors 5 verbunden sind. Ein Emitteranschluß des ersten Stromquellentransistors 5 ist über einen ersten Widerstand 6 mit Masse verbunden.

Der erste Stromquellentransistor 5 ist mit seinem Basisanschluß mit dem Basisanschluß eines ersten Speisetransistors 7 verbunden, dessen Emitteranschluß über einen ersten Speisewiderstand 8 ebenfalls mit Masse verbunden ist. Ein weiterer Transistor 9 ist mit seinem Emitteranschluß mit den miteinander verbundenen Basisanschlüssen des ersten Stromquellentransistors 5 und des ersten Speisetransistors 7 verbunden, wohingegen er mit seinem Basisanschluß mit dem Kollektoranschluß des ersten Speisetransistors 7 und mit seinem Kollektoranschluß mit einem Versorgungsspannungsanschluß 10 verbunden ist. Die Verbindung zwischen dem Basisanschluß des weiteren Transistors 9 und dem Kollektoranschluß des ersten Speisetransistors 7 ist zudem über eine erste Konstantstromquelle 11 ebenfalls mit dem Versorgungsspannungsanschluß 10 verbunden. Der erste Stromquellentransistor 5, der erste Speisetransistor 7, der weitere Transistor 9, die Widerstände 6, 8 und die erste Konstantstromquelle 11 wirken in der Weise einer Stromspiegelanordnung zusammen, durch die ein von der ersten Konstantstromquelle 11 bestimmter Emittergleichstrom dem Paar emittergekoppelter Transistoren 3, 4 aufgeprägt wird.

Der zweite, linearisierte Differenzverstärker 2 umfaßt ein erstes Paar emittergekoppelter Transistoren 12, 13, die, wie im übrigen vorteilhaft auch alle sonstigen, in Fig. 1 dargestellten Transistoren, als bipolare, flächige Transistoren ausgebildet sind. Die miteinander verbundenen Emitteranschlüsse der Transistoren 12, 13 dieses ersten Paares des zweiten Differenzverstärkers 2 sind mit dem Kollektoranschluß eines zweiten Stromquellentransistors 16 verbunden, dessen Emitteranschluß über einen zweiten Widerstand 17 mit Masse gekoppelt ist und dessen Basisanschluß mit dem Basisanschluß des ersten Stromquellentransistors 5 verbunden ist. Außerdem umfaßt der zweite Differenzverstärker 2 ein zweites Paar emittergekoppelter Transistoren 14, 15, deren miteinander verbundene Emitteranschlüsse mit dem Kollektoranschluß eines dritten Stromquellentransistors 18 verbunden sind, dessen Emitteranschluß über einen dritten Widerstand 19 mit Masse gekoppelt und dessen Basisanschluß ebenfalls mit dem Basisanschluß des ersten Stromquellentransistors 5 verbunden ist. Auf diese Weise werden die Emittergleichströme der Differenzverstärker 1, 2 gemeinsam über die erste Konstantstromquelle 11 eingestellt.

Die Basisanschlüsse jedes ersten Transistors 3, 12, 14 der Paare emittergekoppelter Transistoren in den Differenzverstärkern 1, 2 sind miteinander verbunden und bilden einen ersten Eingangsanschluß 20 der Schaltungsanordnung aus den beiden Differenzverstärkern 1, 2, die zumindest abschnittsweise eine Gesamtübertragungsfunktion wenigstens näherungsweise dritten Grades aufweist. Entsprechend sind die Basisanschlüsse aller zweiten Transistoren 4, 13, 15 der Paare emittergekoppelter Transistoren der Differenzverstärker 1, 2 zu einem zweiten Eingangsanschluß der genannten Schaltungsanordnung verbunden. Weiterhin sind die Kollektoranschlüsse des ersten Transistors 3 des ersten Differenzverstärkers 1 und der zweiten Transistoren 13, 15 der dem zweiten Differenzverstärker 2 zugehörigen Paare emittergekoppelter Transistoren miteinander zu einem Ausgangsanschluß 22 verbunden, an dem ein Ausgangssignal der Schaltungsanordnung 1, 2 abgegriffen werden kann, welches die genannte Abhängigkeit dritten Grades von einem den Eingangsanschlüssen 20, 21 zugeführten Eingangssignal aufweist. Des weiteren sind die Kollektoranschlüsse des zweiten Transistors 4 des ersten Differenzverstärkers 1 und der ersten Transistoren 12, 14 der beiden Paare emittergekoppelter Transistoren des zweiten Differenzverstärkers 2 in einem ersten Verbindungspunkt 23 miteinander verbunden. Der erste Verbindungspunkt 23 bildet einen Eingangsanschluß eines Stromspiegels 24, der einen ersten und einen zweiten Stromspiegeltransistor 25 bzw. 26 umfaßt. Die Emitteranschlüsse des ersten bzw. des zweiten Stromspiegeltransistors 25 bzw. 26 sind über einen ersten bzw. einen zweiten Stromspiegelwiderstand 27 bzw. 28 mit dem Versorgungsspannungsanschluß 10 verbunden. Der erste Verbindungspunkt 23, d.h. der Eingang des Stromspiegels 24, ist unmittelbar mit dem Basisanschluß des zweiten Stromspiegeltransistors 26 und über einen dritten Stromspiegelwiderstand 29 mit dem Basisanschluß des ersten Stromspiegeltransistors 25 verbunden. Der Kollektoranschluß des zweiten Stromspiegeltransistors 26 ist mit dem Ausgangsanschluß 22 verbunden.

Während der erste Differenzverstärker eine nicht linearisierte Einzelübertragungsfunktion aufweist, ist diese beim zweiten Differenzverstärker 2 dadurch gegenüber derjenigen des ersten Differenzverstärkers 1 in ihrer Steigung im linearen Bereich vermindert, daß die Emitterflächen des zweiten Transistors 13 des ersten Paares emittergekoppelter Transistoren im zweiten Differenzverstärker 2 und des ersten Transistors 14 des zweiten Paares einander gleich und um einen vorgegebenen Faktor kleiner sind als die einander gleichen Emitterflächen der beiden anderen Transistoren, d.h. des ersten Transistors 12 des ersten Paares und des zweiten Transistors 15 des zweiten Paares. In einem bevorzugten Ausführungsbeispiel nimmt dieser Faktor den Wert 5 an. Wie in der DE-OS 30 27 071, auf deren Offenbarungsgehalt hiermit ausdrücklich Bezug genommen wird, ausführlich dargestellt ist, wird durch eine derartige Dimensionierung der Transistoren der beiden Paare des zweiten Differenzverstärkers 2 eine Verringerung der Steigung der Einzelübertragungsfunktion dieses zweiten Differenzverstärkers 2 gegenüber der nicht linearisierten Einzelübertragungsfunktion des ersten Differenzverstärkers 1 erreicht. Durch entsprechende Dimensionierung der Flächenverhältnisse des zweiten und dritten Stromquellentransistors 16 bzw. 18 zum ersten Stromquellentransistor 5 und der zugehörigen Dimensionierung der Widerstände 6, 17, 19 werden außerdem unterschiedliche Emittergleichströme in die Paare emittergekoppelter Transistoren des ersten bzw. des zweiten Differenzverstärkers 1 bzw. 2 eingespeist, wodurch sich für diese Differenzverstärker 1 bzw. 2 unterschiedliche Grenzwerte in den Sättigungsbereichen ihrer Einzelübertragungsfunktionen ergeben. Im speziellen Dimensionierungsbeispiel nach Fig. 1 wird der gesamte Strom durch den zweiten Differenzverstärker 2 größer gewählt als derjenige durch den ersten Differenzverstärker 1, wodurch sich für den zweiten Differenzverstärker 2 größere Grenzwerte als für den ersten Differenzverstärker 1 ergeben.

Durch den Stromspiegel 24 wird die Differenz der Ströme in den mit dem Ausgangsanschluß 22 verbundenen Kollektoranschlüssen der Transistoren 3, 13, 15 der Differenzverstärker 1 bzw. 2 einerseits und der Ströme in den mit dem ersten Verbindungspunkt 23 verbundenen Kollektoranschlüssen der Transistoren 4, 12, 14 andererseits gebildet und am Ausgangsanschluß 22 abgegeben. Wird dagegen der Ausgang der Schaltungsanordnung aus den Differenzverstärkern 1, 2 als zweipoliger Gegentaktausgang ausgeführt, können anstelle des Stromspiegels 24 beispielsweise zwei Kollektorarbeitswiderstände gegen den Versorgungsspannungsanschluß 10 geschaltet werden. Im Ausführungsbeispiel nach Fig. 1 kann jedoch die Spannung bzw. der Strom am Ausgangsanschluß 22 als Ausgangssignal unmittelbar weiterverarbeitet werden, vorzugsweise als Stellsignal in einem Stellelement.

Die Anordnung nach Fig. 1 ist vorzugsweise zur Kompensation der kubischen Temperatur-Resonanzfrequenz-Kennlinienfunktion eines Schwingquarzes vorgesehen, wozu der Ausgangsanschluß 22 mit einer als Stellelement für die Resonanzfrequenz des Schwingquarzes zu verwendenden Kapazitätsdiode gekoppelt ist. Das am Ausgangsanschluß 22 abgegebene Ausgangssignal - eine Gleichspannung bzw. ein Gleichstrom - dient dabei zur Einstellung des Kapazitätswertes der Kapazitätsdiode. Diese ist beispielsweise in Reihe mit dem genannten Schwingquarz geschaltet und beeinflußt so dessen Resonanzfrequenz.

Als Meßelement zum Bilden eines Meßsignals, dessen Wert ein Maß für die Temperatur des Schwingquarzes darstellt und der wenigstens nahezu linear von dieser Temperatur abhängig ist, dient eine ebenfalls in Fig. 1 dargestellte und mit den Eingangsanschlüssen 20, 21 der aus den Differenzverstärkern 1, 2 gebildeten Schaltungsanordnung verbundene Stufe aus zwei emittergekoppelten Meßtransistoren 30 bzw. 31, die im Ausführungsbeispiel nach Fig. 1 vom entgegengesetzten Leitungstyp wie die Transistoren der Differenzverstärker 1, 2 sind. Die Kollektoranschlüsse der Meßtransistoren 30 bzw. 31 sind über Kollektorwiderstände 32 bzw. 33 mit Masse gekoppelt. Die Emitteranschlüsse der Meßtransistoren 30, 31 sind gemeinsam mit einem Kollektoranschluß eines vierten Stromquellentransistors 34 vom selben Leitungstyp wie die Meßtransistoren 30, 31 verbunden. Der Emitteranschluß des vierten Stromquellentransistors ist über einen vierten Widerstand 35 mit dem Versorgungsspannungsanschluß 10 gekoppelt. Der vierte Stromquellentransistor 34 und der vierte Widerstand 35 sind in der Art eines Stromspiegels mit einem zweiten Speisetransistor 36 vom selben Leitungstyp wie die Meßtransistoren 30, 31 und einem zweiten Speisewiderstand 37 gekoppelt. Dabei sind die Basisanschlüsse des vierten Stromquellentransistors 34 und des zweiten Speisetransistors 36 miteinander und mit dem Kollektoranschluß des zweiten Speisetransistors 36 verbunden, und der Emitteranschluß des zweiten Speisetransistors 36 ist über den zweiten Speisewiderstand 37 mit dem Versorgungsspannungsanschluß 10 gekoppelt. Über eine zweite Konstantstromquelle 38 wird in den zweiten Speisetransistor 36 ein Gleichstrom eingeprägt, der zu einem entsprechend der Dimensionierung der Transistoren 34, 36 und der Widerstände 35, 37 ausgebildeten Gleichstrom durch den vierten Stromquellentransistor 34 und damit die Meßtransistoren 30, 31 führt.

Ein Spannungsteiler enthält in Reihenschaltung einen fünften Widerstand 39, einen fünften Stromquellentransistor 40, einen ersten Teilerwiderstand 41 und einen zweiten Teilerwiderstand 42, die in der Reihenfolge ihrer vorstehenden Aufzählung aufgereiht zwischen dem Versorgungsspannungsanschluß 10 und Masse angeordnet sind. Der Basisanschluß des ersten Meßtransistors 30 ist mit dem Verbindungspunkt zwischen dem ersten und dem zweiten Teilerwiderstand 41 und 42 verbunden, und der Basisanschluß des zweiten Meßtransistors 31 ist an den Verbindungspunkt zwischen dem ersten Teilerwiderstand 41 und dem Kollektoranschluß des fünften Stromquellentransistors 40 angeschlossen. Den Basisanschlüssen der Meßtransistoren 30, 31 ist somit eine durch den Strom im fünften Stromquellentransistor 40 beeinflußbare Spannung, die am ersten Teilerwiderstand 41 auftritt, zuleitbar. Der fünfte Widerstand 39, und der fünfte Stromquellentransistor 40 sind mit einem dritten Speisetransistor 43 und einem dritten Speisewiderstand 44 in der Art eines Stromspiegels gekoppelt, wobei die Basisanschlüsse des fünften Stromquellentransistors 40 und des dritten Speisetransistors 43 miteinander und mit dem Kollektoranschluß des dritten Speisetransistors 43 verbunden sind und wobei der Emitteranschluß des dritten Speisetransistors 43 über den dritten Speisewiderstand 44 mit dem Versorgungsspannungsanschluß 10 gekoppelt ist. Eine dritte Konstantstromquelle 45 ist einerseits mit dem Kollektoranschluß des dritten Speisetransistors 43 und andererseits mit Masse verbunden. Durch sie ist der Strom in dem dritten Speisetransistor 43 und damit im fünften Stromquellentransistor 40 und über diesen die Spannung zwischen den Basisanschlüssen der Meßtransistoren 30, 31 vorgebbar. Der fünfte Stromquellentransistor 40 und der dritte Speisetransistor 43 sind vom selben Leitfähigkeitstyp wie die Meßtransistoren 30, 31.

Die Meßtransistoren 30, 31, die ebenfalls als flächige, bipolare Transistoren ausgebildet sind, weisen unterschiedlich große Emitterflächen auf, die in einem vorgegebenen Größenverhältnis zueinander stehen. Dadurch wird die Aufteilung des über den vierten Stromquellentransistor 34 zugeführten Gleichstromes auf die beiden Meßtransistoren 30, 31 von der Temperatur abhängig. Diese Temperaturabhängigkeit weisen in Folge auch die Spannungen auf, die durch die Ströme in den Kollektoranschlüssen der Meßtransistoren 30 bzw. 31 an den Kollektorwiderständen 32 bzw. 33 hervorgerufen werden. Somit wird den damit verkoppelten Eingangsanschlüssen 20, 21 der aus den Differenzverstärkern 1, 2 gebildeten Schaltungsanordnung eine temperaturabhängige Differenzspannung als Eingangssignal zugeleitet.

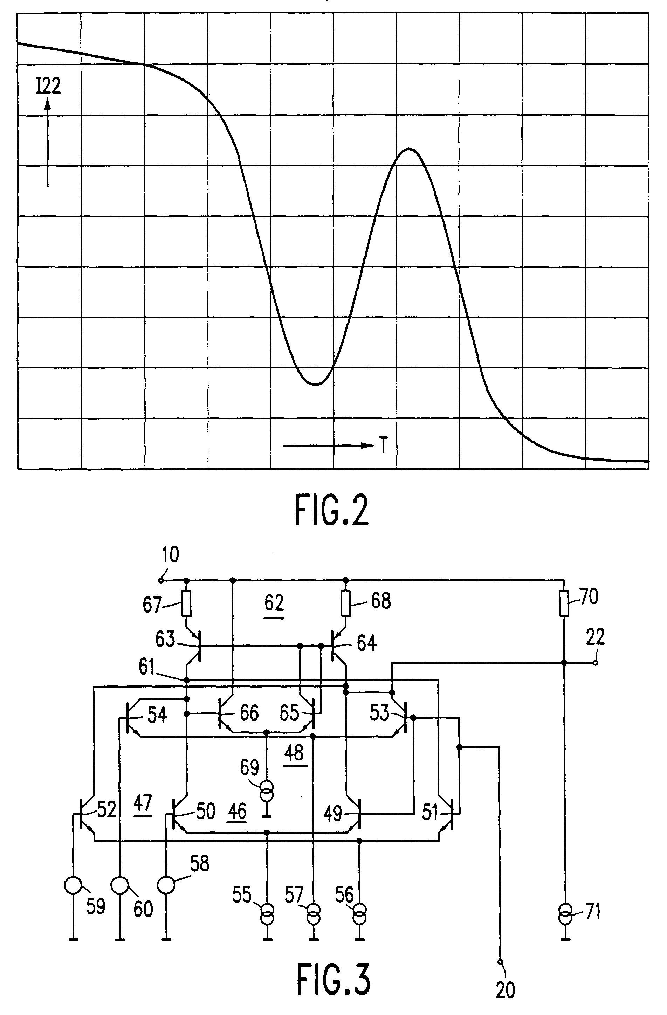

Das durch die Meßtransistoren 30, 31 und die zugehörige Beschaltung gebildete Meßelement erzeugt an den Eingangsanschlüssen 20, 21 als Meßsignal bzw. Eingangssignal eine Spannung, deren Wert wenigstens nahezu linear von der Temperatur der Meßtransistoren 30, 31 abhängt. Daraus wird durch die Schaltungsanordnung aus den Differenzverstärkern 1, 2 ein wenigstens abschnittsweise zumindest weitgehend kubisches Ausgangssignal, beispielsweise ein Ausgangsstrom am Ausgangsanschluß 22, erzeugt. In Fig. 2 ist ein Beispiel für einen derartigen Strom I22 an dem Ausgangsanschluß 22 in Abhängigkeit von der Temperatur T des Schwingquarzes und damit der Meßtransistoren 30, 31 in linearem Maßstab aufgetragen. Dieses Diagramm zeigt im mittleren Abschnitt einen zumindest sehr weitgehend angenäherten Funktionsverlauf dritten Grades, d.h. eine Abhängigkeit des Stromes I22 von der dritten Potenz der Temperatur T.

Aus Fig. 1 ist unmittelbar ersichtlich, daß das aus den Meßtransistoren 30, 31 gebildete Meßelement unmittelbar mit der aus den Differenzverstärkern 1, 2 gebildeten Schaltungsanordnung auf einem Halbleiterkörper integriert und damit sehr kompakt aufgebaut werden kann. In Abweichung davon kann auch ein anderes, z.B. externes Meßelement an die Eingangsanschlüsse 20, 21 angeschlossen werden.

Durch entsprechende Dimensionierung der Schaltungsanordnung nach Fig. 1, insbesondere der Stromquellentransistoren 5, 16, 18 und des ersten Speisetransistors 7 mit zugehöriger Beschaltung sowie durch die Wahl der Größenverhältnisse der Emitterflächen der Differenzverstärker 1, 2 können unterschiedliche Gesamtübertragungsfunktionen erhalten werden, wodurch eine Anpassung der Schaltungsanordnung an unterschiedliche Kenndaten von Schwingquarzen (oder anderen zu kompensierenden Elementen) einfach möglich ist. Wird für eine externe Steuerbarkeit der Konstantstromquellen, insbesondere der ersten Konstantstromquelle 11, Sorge getragen, kann auch nach Fertigstellung der gesamten Anordnung noch ein Abgleich erfolgen. Dabei können eventuell vorhandene, lineare Koeffizienten der Kennlinienfunktion, deren Temperaturgang kompensiert werden soll, noch dadurch berücksichtigt werden, daß die von den Konstantstromquellen 11, 38 bzw. 45 gelieferten Ströme ebenfalls wahlweise linear temperaturabhängig gemacht werden, d.h. linear mit der Temperatur variieren.

Fig. 3 zeigt ein weiteres Ausführungsbeispiel einer Schaltungsanordnung zum Darstellen einer Gesamtübertragungsfunktion wenigstens abschnittsweise zumindest nahezu dritten Grades, die in Fig. 1 anstelle der Schaltungsanordnung aus den Differenzverstärkern 1, 2 zwischen den Eingangsanschluß 20 bzw. 21 einerseits und den Ausgangsanschluß 22 andererseits eingefügt werden kann. Dabei erfolgt die Zuführung des Meßsignals bzw. des Eingangssignals vom Meßelement her nun einpolig, so daß bei der Schaltungsanordnung nach Fig. 3 nur ein erster Eingangsanschluß 20 vorhanden ist. Im übrigen sind mit Fig. 1 übereinstimmende Elemente in Fig. 3 mit denselben Bezugszeichen versehen.

Die Schaltungsanordnung nach Fig. 3 umfaßt drei gleiche, nicht linearisierte Differenzverstärker 46, 47 und 48, die aus je einem Paar emittergekoppelter Transistoren 49, 50 für den dritten Differenzverstärker 46, 51, 52 für den vierten Differenzverstärker 47 und 53, 54 für den fünften Differenzverstärker 48 sowie aus je einer die gekoppelten Emitteranschlüsse speisenden Stromquelle 55, 56 bzw. 57 bestehen. Die drei Differenzverstärker 46, 47, 48 weisen Einzelübertragungsfunktionen mit zumindest weitgehend übereinstimmenden Steigungen in ihren linearen Bereichen sowie ebenfalls weitgehend übereinstimmenden Grenzwerten in ihren Sättigungsbereichen auf. Dagegen sind die Nullpunkte der Einzelübertragungsfunktionen durch drei Referenzspannungsquellen 58 für den dritten Differenzverstärker 46, 59 für den vierten Differenzverstärker 47 bzw. 60 für den fünften Differenzverstärker 48 unterschiedlich vorgegeben. In einer bevorzugten Dimensionierung ist die erste Referenzspannungsquelle 58 zur Abgabe einer Referenzgleichspannung von 1 Volt, die zweite Referenzspannungsquelle 59 zur Abgabe einer Referenzgleichspannung von 1,1 V und die dritte Referenzspannungsquelle 60 zur Abgabe einer Referenzgleichspannung von 1,2 V eingerichtet. Die Stromquellen 55, 56, 57 können entsprechend der Anordnung aus den Stromquellentransistoren 5, 16, 18, den Widerständen 6, 17, 19, dem ersten Speisetransistor 7, dem ersten Speisewiderstand 8, dem weiteren Transistor 9 und der ersten Konstantstromquelle 11 ausgebildet sein, wohingegen die Referenzgleichspannungen aus einem gemeinsamen Referenzspannungsteiler abgeleitet werden können, der beispielsweise in der Art der Spannungsteileranordnung aus Fig. 1 mit den Teilerwiderständen 41, 42, dem fünften Widerstand 39, dem fünften Stromquellentransistor 40, dem dritten Speisetransistor 43, dem dritten Speisewiderstand 44 und der dritten Konstantstromquelle 45 aufgebaut sein kann. Der Übersichtlichkeit halber wurde in Fig. 3 auf eine detailliertere Darstellung verzichtet.

Die Basisanschlüsse der ersten Transistoren 49, 51, 53 des dritten, vierten bzw. fünften Differenzverstärkers 46, 47 bzw. 48 sind gemeinsam mit dem Eingangsanschluß 20 verbunden und werden somit gemeinsam durch das Eingangssignal bzw. Meßsignal angesteuert, wohingegen die zweiten Transistoren 50, 52, 54 mit ihren Basisanschlüssen mit der ersten, zweiten bzw. dritten Referenzspannungsquelle 58, 59, 60 verbunden sind. Die Kollektoranschlüsse des ersten Transistors 49 des dritten Differenzverstärkers 46, des zweiten Transistors 52 des vierten Differenzverstärkers 47 und des ersten Transistors 53 des fünften Differenzverstärkers 48 sind gemeinsam mit dem Ausgangsanschluß 22 verbunden, wohingegen die Kollektoranschlüsse des zweiten Transistors 50 des dritten Differenzverstärkers 46, des ersten Transistors 51 des vierten Differenzverstärkers 47 und des zweiten Transistors 54 des fünften Differenzverstärkers 48 mit einem gemeinsamen Verbindungspunkt 61 verbunden sind. Durch diese Verbindungen der Kollektoranschlüsse wird erreicht, daß die Einzelübertragungsfunktionen der drei Differenzverstärker 46, 47, 48 mit bezüglich der nach den Nullpunkten geordneten Reihenfolge abwechselnd positivem und negativem Vorzeichen überlagert sind, um die Gesamtübertragungsfunktion zu erhalten. Die Einzelübertragungsfunktionen des dritten und des fünften Differenzverstärkers 46 und 48 werden daher mit dem selben Vorzeichen, die Einzelübertragungsfunktion des vierten Differenzverstärkers 47 mit dem entgegengesetzten Vorzeichen in die Gesamtübertragungsfunktion eingehen.

Der Verbindungspunkt 61 und der Ausgangsanschluß 22 sind ähnlich der Fig. 1 auch in der Schaltungsanordnung nach Fig. 3 über einen zweiten Stromspiegel 62 verknüpft, durch den die Differenz der Stromsummen der mit dem Verbindungspunkt 61 bzw. dem Ausgangsanschluß 22 verbundenen Kollektoranschlüsse gebildet wird, um am Ausgangsanschluß 22 eine unsymmetrische, einpolige Ausgangsspannung (Ausgangssignal) zur Verfügung stellen zu können. Der zweite Stromspiegel 62 enthält dazu einen dritten Stromspiegeltransistor 63, dessen Kollektoranschluß mit dem Verbindungspunkt 61 verbunden ist und dessen Emitteranschluß über einen vierten Stromspiegelwiderstand 67 mit dem Versorgungsspannungsanschluß 10 gekoppelt ist. Mit dem Basisanschluß des dritten Stromspiegeltransistors 63 sind die Basisanschlüsse eines vierten und eines fünften Stromspiegeltransistors 64 bzw. 65 sowie der Kollektoranschluß des fünften Stromspiegeltransistors 65 verbunden. Der Kollektoranschluß des vierten Stromspiegeltransistors 64 ist mit dem Ausgangsanschluß 22 verbunden, sein Emitteranschluß ist über einen fünften Stromspiegelwiderstand 68 mit dem Versorgungsspannungsanschluß 10 gekoppelt. Ein sechster Stromspiegeltransistor 66 ist mit seinem Kollektoranschluß ebenfalls mit dem Versorgungsspannungsanschluß 10, mit seinem Basisanschluß mit dem Verbindungspunkt 61 und mit seinem Emitteranschluß in der Art eines Differenzverstärkers mit dem Emitteranschluß des fünften Stromspiegeltransistors 65 sowie einer Emitterstromquelle 69 verbunden, die andererseits an Masse angeschlossen ist.

Zur Umwandlung des von der Schaltungsanordnung nach Fig. 3 am Ausgangsanschluß 22 abgegebenen Ausgangsstromes (vom zweiten Stromspiegel 62 als Differenzstrom geliefert) ist weiterhin ein Ausgangswiderstand 70 zwischen dem Versorgungsspannungsanschluß 10 und dem Ausgangsanschluß 22 angeordnet. An diesem Ausgangswiderstand 70 erzeugt der Ausgangsstrom eine Ausgangsspannung, die unmittelbar zur Steuerung eines Stellelementes als Stellsignal ausgewertet werden kann. Eine zwischen dem Ausgangsanschluß 22 und Masse angeordnete dritte Konstantstromquelle 71 dient dabei der Einstellung des Arbeitspunktes.

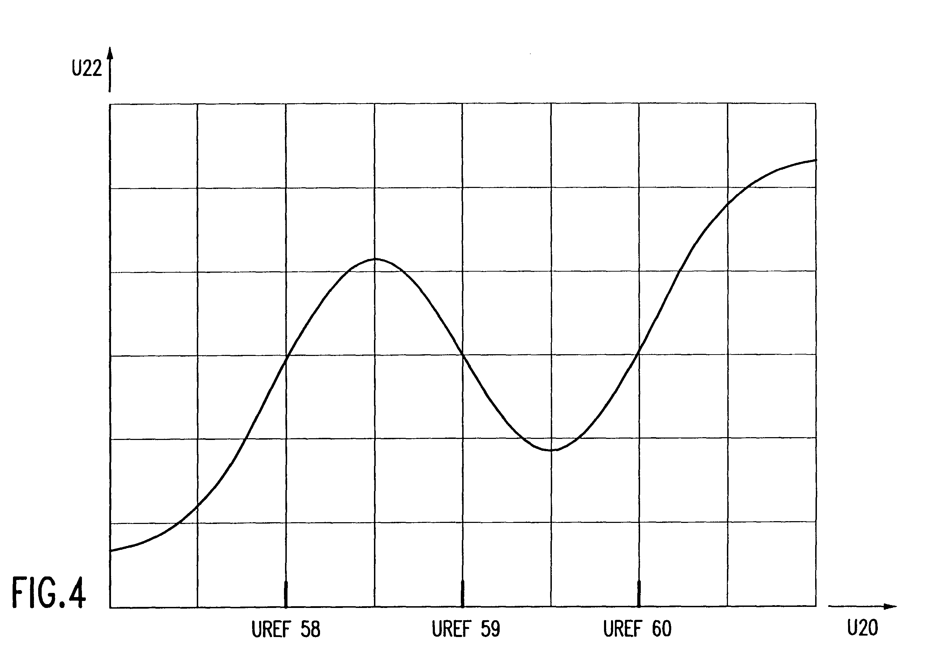

Fig. 4 zeigt ein Beispiel für eine mit der Schaltungsanordnung nach Fig. 3 erreichbare Gesamtübertragungsfunktion zwischen einer als Eingangssignal dem Eingangsanschluß 20 zuführbaren Spannung U20 und einer als Ausgangssignal am Ausgangsanschluß 22 abgreifbaren Spannung U22. In dieses Diagramm sind außerdem die von den Referenzspannungsquellen 58, 59, 60 gelieferten Referenzgleichspannungen URF58, UREF59 bzw. UREF60 eingetragen. Im obigen Dimensionierungsbeispiel betragen diese 1,0 V, 1,1 V bzw. 1,2 V. Im Diagramm nach Fig. 4 ist in der Umgebung dieser Referenzgleichspannungen sehr gut der wenigstens nahezu kubische Verlauf der Gesamtübertragungsfunktion zu erkennen.

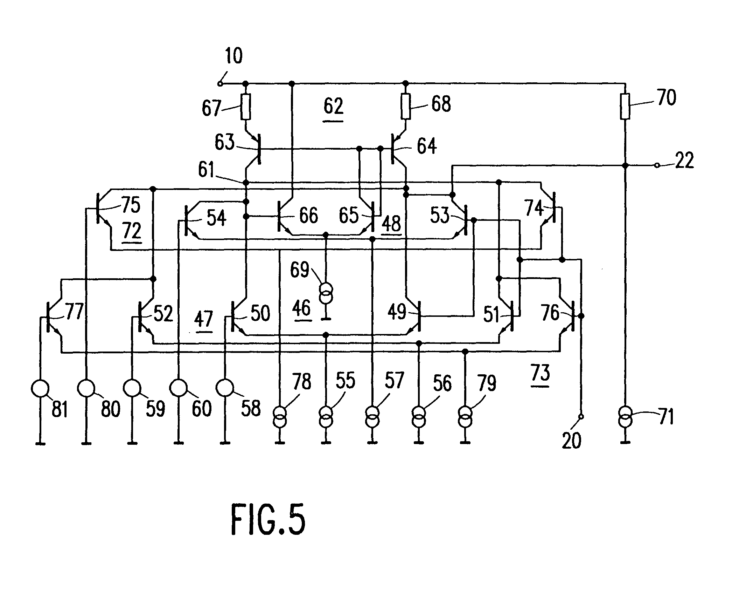

Fig. 5 zeigt eine Abwandlung des Ausführungsbeispiels nach Fig. 3, in der die aus Fig. 3 bekannte Schaltungsanordnung, deren Elemente in Fig. 5 wieder mit denselben Bezugszeichen erscheinen, um einen sechsten und einen siebten Differenzverstärker 72, 73 mit zugehöriger Beschaltung erweitert ist. Bevorzugt sind der sechste und der siebte Differenzverstärker 72, 73 ebenfalls nicht linearisiert und in ihrem Aufbau zumindest weitgehend mit dem dritten, vierten bzw. fünften Differenzverstärker 46, 47 bzw. 48 identisch. Der sechste Differenzverstärker 72 umfaßt somit ein Paar emittergekoppelter Transistoren 74, 75, der siebte Differenzverstärker 73 ein Paar emittergekoppelter Transistoren 76, 77. Die miteinander verbundenen Emitteranschlüsse der Transistoren 74, 75 des sechsten Differenzverstärkers 72 sind über eine Stromquelle 78, die miteinander verbundenen Emitteranschlüsse der Transistoren 76, 77 des siebten Differenzverstärkers 73 über eine Stromquelle 79 mit Masse gekoppelt. Der Basisanschluß des zweiten Transistors 75 des sechsten Differenzverstärkers 72 ist über eine vierte Referenzspannungsquelle 80, der Basisanschluß des zweiten Transistors 77 des siebten Differenzverstärkers 73 über eine fünfte Referenzspannungsquelle 81 mit Masse gekoppelt. Die Stromquellen 78, 79 des sechsten bzw. siebten Differenzverstärkers 72 bzw. 73 sind bevorzugt zu den Stromquellen 55 bis 57 des dritten bis fünften Differenzverstärkers 46 bis 48 identisch aufgebaut. Dagegen ist die vierte Referenzspannungsquelle 80 des sechsten Differenzverstärkers 72 zum Liefern einer Referenzgleichspannung UREF80 eingerichtet, die im Beispiel gemäß Fig. 5 niedriger ist als die Referenzgleichspannung UREF58 der ersten Referenzspannungsquelle 58, und die fünfte Referenzspannungsquelle 81 des siebten Differenzverstärkers 73 ist zum Lieferen einer Referenzgleichspannung UREF81 eingerichtet, die größer ist als die Referenzgleichspannung UREF60 der dritten Referenzspannungsquelle 60. In einer bevorzugten Dimensionierung wird UREF80 auf 0,9 V und UREF81 auf 1,3 V festgesetzt. Die Kollektoranschlüsse der ersten Transistoren 74, 76 des sechsten und des siebten Differenzverstärkers 72, 73 sind mit dem Verbindungspunkt 61, die Kollektoranschlüsse der zweiten Transistoren 75, 77 des sechsten und des siebten Differenzverstärkers 72, 73 sind mit dem Ausgangsanschluß 22 verbunden.

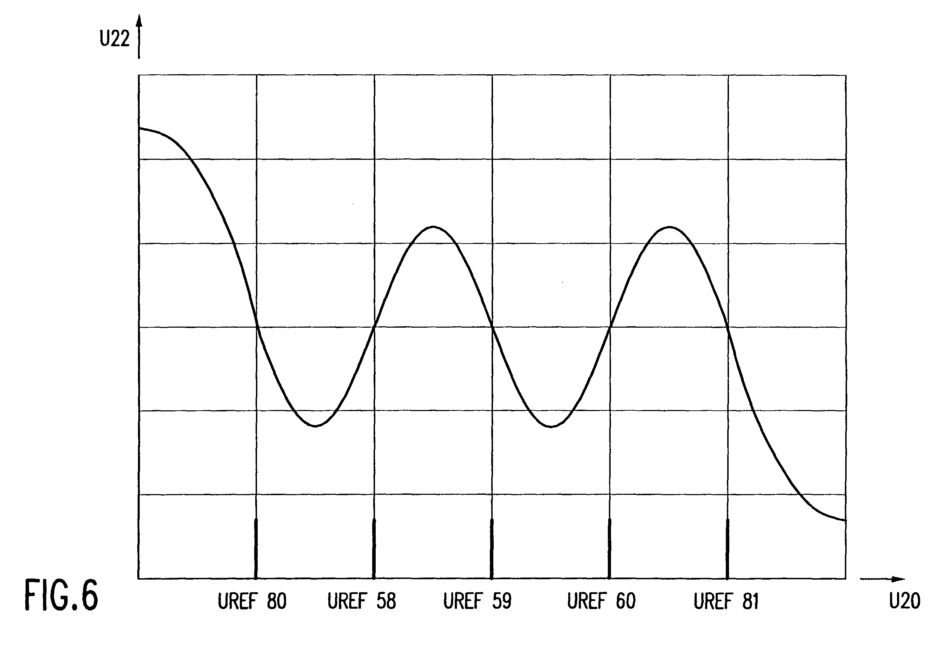

Mit der beschriebenen Auslegung wird durch die Schaltungsanordnung nach Fig. 5 die in Fig. 6 dargestellte Gesamtübertragungsfunktion zwischen der Spannung U20 am Eingangsanschluß 20 (Eingangssignal) und der Spannung U22 am Ausgangsanschluß 22 (Ausgangssignal) erhalten. In der Umgebung der Referenzgleichspannungen UREF58 bis UREF60 entspricht der Verlauf der Gesamtübertragungsfunktion nach Fig. 6 demjenigen nach Fig. 4. Zu höheren Spannungswerten des Eingangssignals U20 hin schließt sich an diesen bekannten Verlauf ein weiteres Maximum zwischen den Referenzgleichspannungen UREF60 und UREF81 an, entsprechend ist zu niedrigeren Werten des Eingangssignals U20 hin ein weiteres Minimum zwischen den Referenzgleichspannungen UREF80 und UREF58 hinzugekommen. Die gegenüber Fig. 4 hinzugekommenen Einzelübertragungsfunktionen des sechsten und des siebten Differenzverstärkers 72, 73 sind entsprechend der Reihenfolge der zugehörigen Referenzgleichspannungen UREF80 und UREF81 zur Gesamtübertragungsfunktion mit demselben Vorzeichen überlagert wie die Einzelübertragungsfunktion des vierten Differenzverstärkers 47. Damit besteht die Gesamtübertragungsfunktion nach Fig. 6 aus der Überlagerung von fünf Einzelübertragungsfunktionen mit entsprechend der Reihenfolge der Referenzgleichspannungen UREF80 als der niedrigsten bis UREF81 als der höchsten fortlaufend abwechselnden Vorzeichen. Alle Einzelübertragungsfunktionen weisen dabei übereinstimmende Steigungen in ihren linearen Bereichen und übereinstimmende Grenzwerte in ihren Sättigungsbereichen auf und sind lediglich in ihren Nullpunkten entsprechend den Referenzgleichspannungen gegeneinander verschoben, wodurch sich der in Fig. 6 gezeigte Verlauf einer Funktion wenigstens näherungsweise fünften Grades im Bereich der Referenzgleichspannungen UREF80 bis UREF81 ergibt.

In einer Abwandlung der Schaltungsanordnung nach Fig. 5 können die Anschlüsse des sechsten und des siebten Differenzverstärkers 72, 73 und deren Referenzspannungsquellen 80, 81 so ausgelegt werden, daß beispielsweise sowohl das zusätzliche Maximum als auch das zusätzliche Minimum der Gesamtübertragungsfunktion nach Fig. 6 gegen über derjenigen nach Fig. 4 oberhalb der Referenzgleichspannung UREF60 der dritten Referenzspannungsquelle 60 oder unterhalb der Referenzgleichspannung UREF58 der ersten Referenzspannungsquelle 58 auftreten. Auch sind entsprechend durch weitere Differenzverstärker zusätzliche Minima oder Maxima anfügbar, wodurch weitere Gesamtübertragungsfunktionen auch entsprechend höheren Grades einfach erzeugt werden können.

## Patentansprüche

1. Schaltungsanordnung mit
- einem Eingang (20,21), dem ein Eingangssignal (U20) zuführbar ist,
- einem Ausgang (22) zum Abgreifen eines Ausgangssignals (U22) und
- einer als Verhältnis zwischen dem Ausgangssignal (U22) und dem Eingangssignal (U20) definierten Gesamtübertragungsfunktion, die aus Einzelübertragungsfunktionen von wenigstens zwei Differenzverstärkern (1,2) mit unterschiedlichen Steigungen in ihren linearen Bereichen und unterschiedlichen Grenzwerten in ihren Sättigungsbereichen mit abwechselnd positivem und negativem Vorzeichen gebildet ist,
dadurch gekennzeichnet, daß die Einzelübertragungsfunktionen mit zumindest weitgehend übereinstimmenden Nullpunkten derart überlagert sind, daß die Gesamtübertragungsfunktion zumindest abschnittsweise einen Verlauf annimmt, der wenigstens näherungsweise einer Funktion zumindest dritten Grades entspricht.

2. Schaltungsanordnung nach Anspruch 1,
dadurch gekennzeichnet, daß die Gesamtübertragungsfunktion aus Einzelübertragungsfunktionen von wenigstens zwei Differenzverstärkern (1, 2) mit unterschiedlichen Steigungen in ihren linearen Bereichen und mit bezüglich der Reihenfolge abnehmender Steigungen monoton zunehmenden Grenzwerten in ihren Sättigungsbereichen mit in derselben Reihenfolge abwechselnd positivem und negativem Vorzeichen überlagert ist.

3. Schaltungsanordnung mit
- einem Eingang (20,21), dem ein Eingangssignal (U20) zuführbar ist,
- einem Ausgang (22) zum Abgreifen eines Ausganssignals (U22) und
- einer als Verhältnis zwischen dem Ausgangssignal (U22) und dem Eingangssignal (U20) definierten Gesamtübertragungsfunktion, die aus Einzelübertragungsfunktionen von Differenzverstärkern (46,47,48; 72,73) mit unterschiedlichen Nullpunkten mit bezüglich der nach den Nullpunkten geordneten Reihefolge abwechselnd positivem und negativem Vorzeichen der Steigungen in ihren linearen Bereichen überlagert ist,
dadurch gekennzeichnet, daß die Differenzverstärker
- zumindest weitgehend übereinstimmende Steigungen in ihren linearen Bereichen und weitgehend übereinstimmende Grenzwerte in ihren Sättigungsbereichen aufweisen,
- je zwei Ausgänge bildende Kollektoranschlüsse aufweisen, von denen je einer mit einem ersten, gemeinsamen Verbindungspunkt und der andere mit einem weiteren, gemeinsamen Anschluß verbunden sind, die Gesamtübertragungsfunktion zumindest abschnittsweise einen Verlauf annimmt, der wenigstens näherungsweise einer Funktion zumindest dritten Grades entspricht.

4. Schaltungsanordnung nach Anspruch 1, 2 oder 3, in der die Gesamtübertragungsfunktion zumindest abschnittsweise wenigstens nahezu eine Funktion dritten Grades darstellt, gekennzeichnet durch eine Verbindung mit weiterhin
- einem Schwingquarz mit einer Temperatur-Resonanzfrequenz-Kennlinienfunktion, die zumindest abschnittsweise wenigstens nahezu einer Funktion dritten Grades entspricht,
- einem Stellelement zum Einstellen der Resonanzfrequenz durch ein Stellsignal mit wenigstens nahezu linearer Übertragungscharakteristik zwischen dem Stellsignal und der Resonanzfrequenz,
- einem Meßelement (30, 31) zum Bilden eines Meßsignals, dessen Wert wenigstens nahezu linear von der Temperatur des Schwingquarzes abhängig ist,
wobei das Meßsignal der Schaltungsanordnung (1, 2, 24) als Eingangssignal (an 20, 21) zuführbar ist, die das daraus entsprechend der Gesamtübertragungsfunktion abgeleitete Ausgangssignal (an 22) dem Stellelement als Stellsignal derart zuführt, daß die Resonanzfrequenz des mit dem Stellelement gekoppelten Schwingquarzes im genannten Abschnitt wenigstens nahezu von der Temperatur unabhängig ist.

5. Schaltungsanordnung nach Anspruch 1 oder 2 oder nach Anspruch 4 in Verbindung mit Anspruch 1 oder 2,
dadurch gekennzeichnet, daß die darin verwendeten Differenzverstärker je ein Transistorenpaar aufweisen, dessen Emitteranschlüsse über wenigstens einen Emitterwiderstand gekoppelt sind, wobei die Steigungen der Einzelübertragungsfunktionen der Differenzverstärker in ihren linearen Bereichen durch die Wahl der Widerstandswerte der Emitterwiderstände bestimmbar sind.

6. Schaltungsanordnung nach Anspruch 1 oder 2 oder nach Anspruch 4 in Verbindung mit Anspruch 1 oder 2,
dadurch gekennzeichnet, daß die darin verwendeten Differenzverstärker (2) je ein erstes und zweites Paar erster und zweiter emittergekoppelter, bipolarer, flächiger Transistoren (12, 13 bzw. 14, 15) aufweisen, wobei Basis- und Kollektoranschluß des ersten Transistors (12) des ersten Paares mit dem entsprechenden Anschluß des ersten Transistors (14) des zweiten Paares und Basis- und Kollektoranschluß des zweiten Transistors (13) des ersten Paares mit dem entsprechenden Anschluß des zweiten Transistors (15) des zweiten Paares gekoppelt ist und die Emitterflächen des zweiten Transistors (13) des ersten Paares und des ersten Transistors (14) des zweiten Paares einander gleich und um einen vorgegebenen Faktor größer oder kleiner sind als die einander gleichen Emitterflächen der beiden anderen Transistoren (12, 15).

## Claims

1. A circuit arrangement having
- an input (20, 21), arranged to receive an input signal (U20),
- an output (22) for taking off an output signal (U22), and an overall transfer function defined as the ratio between the output signal (U22) and the input signal (U20) and formed from individual transfer functions of at least two differential amplifiers (1, 2) with different slopes in their linear ranges and different limit values in their saturation ranges alternately with positive and negative signs,
characterised in that the individual transfer functions are added with at least substantially corresponding zero points in such a manner that at least partly the overall transfer function corresponds at least substantially to a function of at least the third degree.

2. A circuit arrangement as claimed in claim 1,
characterised in that the overall transfer function is formed by addition of individual transfer functions of at least two differential amplifiers (1, 2) with different slopes in their linear ranges and with limit values in their saturation ranges, which limit values increase monotonically in the sequence of decreasing slopes, alternately with positive and negative signs in the same sequence.

3. A circuit arrangement having
- an input (20, 21), arranged to receive an input signal (U20),
- an output (22) for taking off an output signal (U22), and an overall transfer function defined as the ratio between the output signal (U22) and the input signal (U20) and obtained by adding individual transfer functions of differential amplifiers (46, 47, 48; 72, 73) with different zero points alternately with positive and negative signs of the slopes in their linear ranges in the sequence of the zero points,
characterised in that the differential amplifiers have
- at least substantially corresponding slopes in their linear ranges and substantially corresponding limit values in their saturation ranges,
- collector terminals constituting two outputs, one of which is connected to a first, common junction point and the other is connected to a further, common terminal, while at least partly the overall transfer function corresponds at least substantially to a function of at least the third degree.

4. A circuit arrangement as claimed in claim 1, 2 or 3, in which the overall transfer function is at least partly a function of at least substantially the third degree,
characterised by a combination with, in addition,
- a quartz crystal having a temperature-versus-resonant-frequency characteristic function which at least partly corresponds to a function of at least substantially the third degree,
- a correction element for correcting the resonant frequency by a correction signal with an at least substantially linear transfer characteristic between the correction signal and the resonant frequency,
- a measuring element (30, 31) for forming a measurement signal whose value has an at least substantially linear dependence on the temperature of the quartz crystal,
the measurement signal being applicable to the circuit arrangement (1, 2, 24) as an input signal (at 20, 21), which arrangement applies the output signal (at 22), derived from said input signal in accordance with the overall transfer function, to the correction element as the correction signal in such manner that the resonant frequency of the quartz crystal coupled to the correction element is at least substantially temperature independent in said range.

5. A circuit arrangement as claimed in claim 1 or 2 or as claimed in claim 4 where appendant to claim 1 or 2,
characterised in that the differential amplifiers used therein each comprise a transistor pair whose emitter terminals are coupled *via* at least one emitter resistor, the slopes of the individual transfer functions of the differential amplifiers in their linear ranges being adjustable by an appropriate choice of the resistance values of the emitter resistors.

6. A circuit arrangement as claimed in claim 1 or 2 or as claimed in claim 4 where appendant to claim 1 or 2,
characterised in that the differential amplifiers (2) used therein each comprise a first and a second pair of first and second emitter-coupled bipolar planar transistors (12, 13 and 14, 15, respectively), the base and the collector terminal of the first transistor (12) of the first pair being coupled to the corresponding terminal of the first transistor (14) of the second pair and the base and the collector terminal of the second transistor (13) of the first pair being coupled to the corresponding terminal of the second transistor (15) of the second pair, and the emitter areas of the second transistor (13) of the first pair and the first transistor (14) of the second pair being equal to one another and being a given factor larger or smaller than the mutually equal emitter areas of the two other transistors (12, 15).

## Revendications

1. Circuit avec
- une entrée (20, 21) à laquelle peut être amené un signal d'entrée (U20),
- une sortie (22) en vue de prélever un signal de sortie (U22) et
- une fonction de transmission composée définie comme le rapport entre le signal de sortie (U22) et le signal d'entrée (U20) qui est formée à partir de fonctions de transmission individuelle d'au moins deux amplificateurs différenciateurs (1,2) avec des pentes différentes dans leurs zones linéaires et des valeurs limite différentes dans leurs zones de saturation avec des signes en alternance positifs et négatifs,
caractérisé en ce que les fonctions de transmission individuelle sont superposées avec des points zéro correspondants, du moins en grande partie, de telle sorte que la fonction de transmission composée adopte du moins par segment un tracé qui correspond, du moins approximativement, à une fonction de troisième degré au moins.

2. Circuit selon la revendication 1,
caractérisé en ce que la fonction de transmission composée de fonction de transmission individuelle d'au moins deux amplificateurs différenciateurs (1,2) avec des pentes différentes dans leurs zones linéaires et avec des valeurs limite augmentant régulièrement par rapport à l'ordre des pentes descendantes dans leurs zones de saturation est superposée avec des signes en alternance positifs et négatifs dans le même ordre.

3. Circuit avec
- une entrée (20, 21) à laquelle peut être amené un signal d'entrée (U20),
- une sortie (22) en vue de prélever un signal de sortie (U22) et
- une fonction de transmission composée définie comme le rapport entre le signal de sortie (U22) et le signal d'entrée (U20) qui est superposée à partir de fonctions de transmission individuelle d'amplificateurs différenciateurs (46, 47, 48; 72, 73) avec des points zéro différents avec un signe en alternance positif et négatif en fonction de l'ordre classé selon les points zéro aux pentes dans leurs zones linéaires,
caractérisé en ce que les amplificateurs différenciateurs
- présentent des pentes correspondantes du moins en grande partie dans leurs zones linéaires et des valeurs limite correspondantes en grande partie dans leurs zones de saturation,
- présentent respectivement des bornes de collecteur formant deux sorties desquelles l'une est reliée à un premier point de connexion commun et l'autre à une autre borne commune,
- la fonction de transmission composée adoptant du moins par segment un tracé qui correspond du moins approximativement à une fonction de troisième degré au moins.

4. Circuit selon l'une des revendications 1, 2 ou 3 dans lequel la fonction de transmission composée représente du moins par segment une fonction de troisième degré ou approximativement,
caractérisé par une connexion avec, par ailleurs:
- un quartz oscillant avec une fonction caractéristique température/fréquence de résonance qui correspond du moins par segment à une fonction de troisième degré, ou du moins presque
- un élément de réglage en vue du réglage de la fréquence de résonance par un signal de réglage avec une caractéristique de transmission linéaire ou presque entre le signal de réglage et la fréquence de résonance,
- un élément de mesure (30, 31) en vue de la formation d'un signal de mesure dont la valeur dépend de manière linéaire ou presque de la température du quartz oscillant,
le signal de mesure du circuit (1, 2, 24) pouvant être amené comme un signal d'entrée (en 20, 21) qui amène le signal de sortie (en 22) dérivé de là conformément à la fonction de transmission composée à l'élément de réglage sous forme de signal de réglage, que la fréquence de résonance du quartz oscillant couplé à l'élément de réglage est indépendante ou du moins presque de la température dans ledit segment.

5. Circuit selon l'une des revendications 1 ou 2 ou selon la revendication 4 connexe aux revendications 1 ou 2,
caractérisé en ce que les amplificateurs différenciateurs utilisés dans celui-ci présentent respectivement une paire de transistors dont les bornes d'émetteurs sont couplées par l'intermédiaire d'au moins une résistance d'émetteurs, les pentes de fonction de transmission individuelle des amplificateurs différenciateurs pouvant être déterminées dans leurs zones linéaires par le choix de valeur de résistance des résistances d'émetteur.

6. Circuit selon l'une des revendications 1 ou 2 ou revendication 4 connexe aux revendications 1 ou 2,
caractérisé en ce que les amplificateurs différenciateurs utilisés (2) présentent respectivement une première et une deuxième paires de premiers et deuxièmes transistors couplés par l'émetteur, bipolaires et plats (12, 13 ou 14, 15), la borne de base et la borne de collecteur du premier transistor (12) de la première paire étant reliées à la borne correspondante du premier transistor (14) de la deuxième paire et la borne de base et la borne de collecteur du deuxième transistor (13) de la première paire étant reliées à la borne correspondante du deuxième transistor (15) de la deuxième paire et les surfaces d'émetteur du deuxième transistor (13) de la première paire et du premier transistor (14) de la deuxième paire étant identiques entre elles et supérieures ou inférieures d'un facteur préalablement déterminé aux surfaces d'émetteur identiques entre elles des deux autres transistors (12, 15).
